# DEMANDE DE BREVET EUROPEEN

(11) **EP 1 860 466 A1**
(43) Date de publication de la demande: **28.11.2007**
(21) Numéro de dépôt: 07009768.8
(22) Date de dépôt: 16.05.2007
(51) Int. Cl.: G02B 3/00, G02B 13/00

(54) **Procédé de fabrication de lentilles, notamment pour imageur CMOS**

(30) Priorité: 23.05.2006 FR 0604636
(71) Demandeur: STMicroelectronics (Rousset) SAS, 13790 Rousset (FR); STMicroelectronics S.A., 13106 Rousset cedex (FR)
(72) Inventeur: Hernandez, Caroline, 13860 Peyroles (FR)
(74) Mandataire: Marchand, André

(57) **Abrégé**

L'invention concerne un procédé de fabrication d'au moins une lentille optique à partir d'une matière (50) liquide ou gélatineuse durcissable, comprenant une étape de dépôt d'un volume calibré de la matière (50) sur un support (40) de formation de lentille, au moyen d'une aiguille creuse (33) de faible diamètre, de manière que le volume de matière déposée présente au moins une partie convexe sous l'effet d'énergies d'interface, et une étape de durcissement de tout ou partie du volume de matière déposé. Application notamment à la réalisation de lentilles pour imageurs CMOS.

## Description

La présente invention concerne la fabrication de lentilles optiques et notamment de lentilles pour imageurs CMOS.

Les imageurs réalisés selon la technologie CMOS ("Complementary Metal Oxide Semiconductor") font actuellement l'objet d'un nombre croissant d'applications en raison de leur faible prix de revient comparativement aux imageurs CCD (Charge Coupled Device). De tels imageurs CMOS étaient initialement utilisés pour réaliser des capteurs d'image à faible résolution et de qualité médiocre (par exemple des caméras web). Aujourd'hui, après un important investissement en recherche et développement, les imageurs CMOS peuvent rivaliser avec les imageurs CCD. La présente invention s'inscrit dans un effort de perfectionnement de cette technologie d'imageurs visant une baisse des prix de revient à qualité égale.

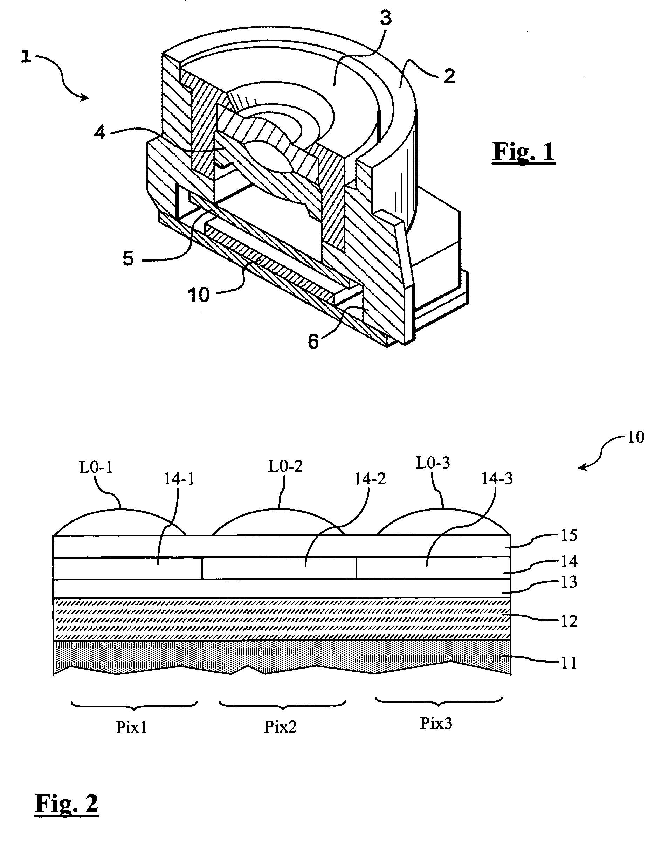

La figure 1 représente un exemple de module de capture d'images et/ou de capture vidéo utilisant un imageur CMOS, destiné par exemple à être monté dans un appareil portatif tel un téléphone mobile, un appareil photographique ou une caméra vidéo. Le module 1 comprend un châssis 2, un bloc optique ou bloc porte-lentilles 3, une lentille 4 solidaire du bloc 3, un filtre infrarouge 5 et un support 6. Un imageur CMOS 10 est disposé sur le support 6 et reçoit la lumière passant à travers les microlentilles et le filtre infrarouge.

L'imageur CMOS 10 se présente sous la forme d'une microplaquette de semi-conducteur et comprend une pluralité de photosites formant chacun un pixel (non visibles sur la figure 1). Chaque pixel comprend une photodiode et un circuit de contrôle et d'interconnexion de la photodiode. Les pixels sont agencés de façon matricielle et une mosaïque de filtres rouges, verts, bleus est répartie au-dessus de la matrice de pixels, généralement selon l'architecture de Bayer (les cellules d'une ligne étant alternativement rouges et vertes ou alternativement vertes et bleues). Chaque pixel est ainsi recouvert par un filtre de couleur primaire déterminée, rouge, verte ou bleue, et fournit une information de luminance relative à la couleur primaire qui lui est attribuée, formant une information de pixel.

La figure 2 est une vue en coupe schématique de l'imageur CMOS 10 dans une région correspondant à trois pixels PIX1, PIX2, PIX3. En allant du bas vers le haut, on distingue des couches 11, 12, 13, 14, 15 et des microlentilles L0 (L0-1, L0-2, L0-3). La couche 11 est le substrat semi-conducteur sur lequel l'imageur est implanté. Cette couche 11 représente ainsi la partie active de l'imageur et comprend des photodiodes et leurs circuits de contrôle et d'interconnexion associés (non détaillés). La couche 12 est formée par un matériau diélectrique qui recouvre entièrement le substrat 11. La couche 13 est une couche de passivation déposée sur l'imageur en fin de processus de fabrication CMOS. La couche 14 est formée par des résines colorées et comprend des secteurs 14-1, 14-2, 14-3 de couleur rouge, verte ou bleue formant les filtres de couleur primaire susmentionnés, à raison d'un filtre de couleur par pixel. La couche 15 est une couche de résine intermédiaire formant un support pour les microlentilles L0 et offrant une bonne planéité. Les microlentilles L0 sont agencées en une matrice dite "MLA" ("Microlens Array") à raison d'une microlentille par pixel.

La lentille 4 du bloc optique est généralement formée dans un moule au moyen d'une résine polymère qui est retirée du moule après une étape de cuisson. Une autre technique connue de fabrication de la lentille 4 consiste en une impression de résine polymère sur un support puis fluage de la résine pour obtenir une face convexe (bombée).

Les microlentilles L0 sont également réalisées au moyen d'une résine polymère et leur procédé de fabrication comprend par exemple des étapes de dépôt d'une couche de résine polymère photosensible (photorésine) sur une plaquette d'imageur, une étape de cuisson douce ("soft bake"), une étape d'exposition de la couche de résine à une lumière ultraviolette à travers un masque d'insolation et une étape de retrait des parties insolées avec un solvant organique pour obtenir une matrice de pastilles plates. Les lentilles plates sont ensuite soumises à une température déterminée pour subir un fluage thermique qui rend convexe leur face supérieure. Une opération finale de recuit permet d'assurer leur durcissement.

Ces procédés de fabrication et notamment le procédé de fabrication de la lentille du bloc optique utilisant un moule, présentent l'inconvénient d'être complexes, longs à mettre en oeuvre et sont par conséquent coûteux.

Un objectif de la présente invention est de prévoir un procédé de fabrication de lentille ou de microlentilles qui constitue une alternative avantageuse aux procédés connus.

Cet objectif est atteint par la prévision d'un procédé de fabrication d'au moins une lentille optique à partir d'une matière liquide ou gélatineuse durcissable, comprenant une étape de dépôt d'un volume calibré de la matière sur un support de formation de lentille, au moyen d'une aiguille creuse de faible diamètre, de manière que le volume de matière déposée présente au moins une partie convexe sous l'effet d'énergies d'interface, et une étape de durcissement de tout ou partie du volume de matière déposé.

Selon un mode de réalisation, le volume de matière durci est utilisé comme lentille en le laissant sur son support de formation initial, prévu à cet effet transparent et utilisé comme support de lentille.

Selon un mode de réalisation, le durcissement du volume de matière est partiel et la lentille contient, après durcissement, au moins une partie encore liquide ou gélatineuse.

Selon un mode de réalisation, le volume de matière est déposé sur une partie plate du support de formation et la lentille présente avant durcissement une forme générale convexe sous l'effet des énergies d'interface.

Selon un mode de réalisation, le volume de matière est déposée dans une cavité prévue dans le support de formation, et la lentille présente avant durcissement une face supérieure de forme convexe sous l'effet des énergies d'interface.

Selon un mode de réalisation, le volume de matière est déposé sur le support de formation sans que l'extrémité de l'aiguille pénètre dans le volume de matière déposé.

Selon un mode de réalisation, le volume de matière est déposé sur le support de formation avec une distance entre le support de formation et l'extrémité de l'aiguille qui est telle que l'extrémité de l'aiguille se trouve à l'intérieur du volume de matière après que celui-ci est déposé.

Selon un mode de réalisation, le procédé comprend une étape consistant à injecter au moins un gaz à l'intérieur du volume de matière, pour obtenir une lentille renfermant une poche de gaz.

Selon un mode de réalisation, le procédé comprend au moins une étape consistant à injecter une autre matière liquide ou gélatineuse à l'intérieur du volume de matière déposé, pour obtenir une lentille composite comprenant au moins deux couches sensiblement concentriques ayant des indices optiques différents.

Selon un mode de réalisation, le procédé comprend le dépôt simultané d'une pluralité de volumes de matière sur le support de formation, au moyen d'une pluralité d'aiguilles de faible diamètre, pour obtenir une matrice de lentilles.

Selon un mode de réalisation, le procédé comprend plusieurs étapes simultanées ou successives de dépôt simultané d'une pluralité de volume de matière sur le support de formation, au moyen d'une pluralité d'aiguilles de faible diamètre, en utilisant des matières différentes, pour obtenir une matrice composite de lentilles comprenant des groupes de lentilles ayant des propriétés optiques différentes.

L'invention concerne également un procédé de fabrication d'un capteur d'image numérique, notamment un capteur CMOS, comprenant une étape de fabrication d'une lentille conduite conformément au procédé selon l'invention.

L'invention concerne également un procédé de fabrication d'un appareil photographique, comprenant une étape de fabrication d'un capteur d'image selon l'invention.

L'invention concerne également un procédé de fabrication d'un bloc optique pour capteur d'image numérique, notamment un capteur CMOS, comprenant une étape de fabrication d'une lentille conduite conformément au procédé selon l'invention.

Ces objets, caractéristiques et avantages ainsi que d'autres de la présente invention seront exposés plus en détail dans la description suivante du procédé selon l'invention et de diverses variantes d'exécution de ce procédé, faite à titre non limitatif en relation avec les figures jointes parmi lesquelles:
- la figure 1 précédemment décrite représente un bloc d'imageur CMOS,
- la figure 2 précédemment décrite est une vue en coupe d'une microplaquette d'imageur CMOS,
- les figures 3A à 3C illustrent des étapes du procédé de fabrication de lentille selon l'invention,
- les figures 4A, 4B représentent deux formes de lentilles différentes pouvant être obtenues grâce au procédé de l'invention,
- la figure 5 représente un dispositif permettant de fabriquer collectivement des lentilles conformément au procédé de l'invention,
- les figures 6, 7, 8, 9A et 9B représentent différentes matrices de lentilles réalisées au moyen du procédé de l'invention,
- les figures 10A, 10B et 11A, 11B illustrent un mode de réalisation du procédé de l'invention permettant de réaliser une lentille à charge gazeuse,
- les figures 12A à 12C et 13A, 13B illustrent un mode de réalisation du procédé de l'invention permettant de réaliser une lentille composite ou à charge gazeuse,
- les figures 14A à 14C illustrent un mode de réalisation du procédé de l'invention permettant de réaliser une lentille composite à variation d'indice,
- la figure 15 représente un autre exemple de réalisation d'un dispositif permettant de fabriquer collectivement des lentilles conformément au procédé de l'invention, et
- la figure 16 représente une variante d'une étape de durcissement représentée en figure 3C.

La présente invention se fonde sur un concept simple mais non moins inventif, qui est de former des lentilles à partir d'une matière fluide ou gélatineuse durcissable en utilisant les énergies d'interface qui agissent sur un volume de matière déposé sur une surface pour obtenir une forme de lentille convergente. Après durcissement de la matière, une telle forme est utilisée dans des applications optiques comme la réalisation du bloc lentille d'un imageur numérique tel un imageur CMOS ou la réalisation des microlentilles d'une microplaquette d'imageur CMOS

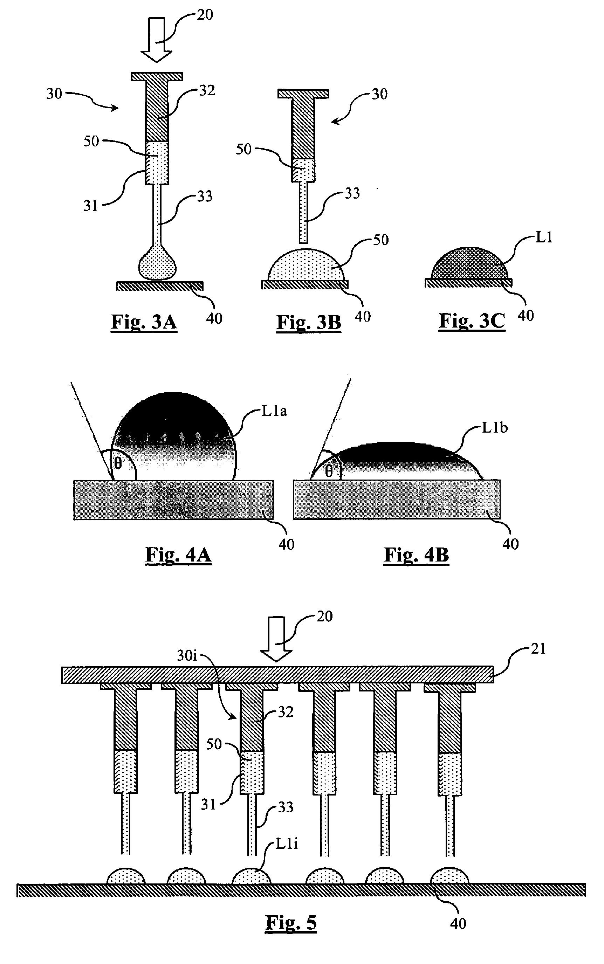

Sur les figures 3A, 3B, un dispositif de dispensation 30 contenant une matière à dispenser 50 est agencé au-dessus d'un support 40 de formation de lentille agencé horizontalement. La matière 50 est liquide ou gélatineuse et présente une viscosité déterminée. La matière 50 est durcissable par séchage ou polymérisation (le séchage étant entendu ici comme incluant la polymérisation, pour une matière polymérisable à température ambiante et sans apport d'énergie).

Le dispositif de dispensation 30 est par exemple une seringue équipée d'une aiguille creuse 33. La seringue 30 comprend un tube 31 et un piston 32, le tube se terminant par une ouverture sur laquelle est fixée l'aiguille 33. Un pousse-seringue 20 (représenté schématiquement par une flèche) applique au piston 32 un mouvement de translation d'amplitude contrôlée, pour dispenser un volume de matière 50 déterminée. Le pousse-seringue est de préférence motorisé, pour un contrôle précis du mouvement de translation.

Un volume déterminé de matière 50 est déposé sur le support 40, comme illustré sur la figure 3B. Ce "volume de matière" a la forme d'une goutte d'eau déposée sur un support imperméable. Selon l'invention, le volume de matière 50 est ensuite durci par séchage ou polymérisation pour obtenir une lentille L1, comme représenté en figure 3C. La lentille peut être détachée du support 40 pour être montée par collage ou sertissage sur un support d'accueil qui est par exemple agencé dans le bloc optique d'un capteur CMOS. Dans un mode d'exécution de l'invention, la lentille L1 n'est pas séparée du support 40 et celui-ci est utilisé en tant que support de lentille. Le support 40 est dans ce cas transparent. Il peut s'agir d'une plaquette de verre, pouvant être colorée ou non. Dans une application, le support 40 est une couche de résine "planar" (couche de résine servant à aplanir des surfaces de semi-conducteur ou d'oxyde en microélectronique après formation de composants sur le semi-conducteur) et la lentille est directement formée sur une plaquette d'imageur.

La présente invention se fonde ainsi sur les lois de la physique pour réaliser une forme utilisable comme lentille. Une tension superficielle, appelée également énergie d'interface ou énergie de surface, existe à l'interface entre deux milieux. Le volume de matière 50 étant posé sur le support 40, il faut considérer ici trois milieux, à savoir l'air pour le milieu ambiant (ou un gaz dans le cas d'une mise en oeuvre du procédé en atmosphère gazeuse contrôlée), le liquide (ou gel) formant le volume de matière 50, et un milieu solide formé par le support 40. La forme du volume de matière 50 est donc déterminée par trois interfaces : gaz/liquide (ou gaz/gel), gaz/solide et liquide/solide. La forme du volume de matière 50 résulte de l'équilibre entre la pression du gaz, l'attraction moléculaire à l'intérieur de la matière 50, le poids de la matière 50, et l'attraction à l'interface liquide/solide. L'énergie interfaciale à l'équilibre dépend des aires de ces trois interfaces (énergie par unité de surface ou densité surfacique d'énergie). La forme que prend le volume de matière 50 est celle qui minimise la somme des énergies d'interface entre les trois milieux (le site web http://www.kruss.info donne diverses informations concernant la tension interfaciale et l'angle de contact d'une goutte de liquide posée sur une surface).

La forme de la goutte obtenue se situe ainsi entre deux extrêmes représentés sur les figures 4A et 4B :
1) une forme d'ellipsoïde L1a coupée en dessous de l'équateur (figure 4A) quand la densité d'énergie de l'interface solide/liquide est grande. Le volume de matière 50 est repoussé par le solide 40 et l'aire de l'interface entre la matière 50 et le support 40 est petite, tandis que l'aire de l'interface entre la matière 50 et l'air est grande (le cas extrême étant une forme de bille). L'angle de contact θ est maximal.
2) une forme d'ellipsoïde L1b tronquée au-dessus de l'équateur (figure 4B) si l'étalement du volume de matière 50 nécessite peu d'énergie (la densité d'énergie de l'interface solide/liquide est faible). Dans ce cas l'aire de l'interface entre la matière 50 et le support 40 est grande, tandis que celle de l'interface entre la matière 50 et l'air est petite (le cas le plus extrême étant une forme de flaque).

Le procédé de l'invention comprend ainsi un choix judicieux entre les paramètres de viscosité et de densité de la matière 50, l'état de surface du support 40, pour obtenir la forme de lentille souhaitée. Également, des paramètres comme la nature du gaz ambiant et la pression ambiante peuvent être contrôlés pour moduler la forme de lentille obtenue. Une étape de traitement de surface (par exemple un polissage ou un traitement par plasma) peut également être appliquée au support 40 pour moduler la forme de lentille obtenue.

La matière 50 utilisée pour mettre en oeuvre l'invention est de préférence un polymère ou une combinaison de polymères, ou un composé contenant un polymère ou une combinaison de polymères additionnés à un liant. Des matériaux différents peuvent y être ajoutés, par exemple des paillettes magnétiques. La matière est par exemple de l'époxy, une matière de passivation appelée "glass" utilisée en microélectronique, une colle... Des prototypes de lentilles selon l'invention ont notamment été réalisés avec une colle référencée "OGR150THTG" commercialisée par la société Ablestick (produit professionnel destiné à la microélectronique). De façon générale et sous réserve d'essais à la portée de l'homme de l'art, toute matière durcissable liquide ou sous forme de gel est utilisable pour mettre en oeuvre l'invention, si tant est qu'elle ne devient pas opaque au durcissement. La matière 50 peut être transparente ou colorée. Elle peut être électriquement isolante ou conductrice.

Le durcissement de la lentille L1 peut être obtenu par voie thermique (selon les conditions de polymérisation des produits utilisés), en utilisant une source de lumière UV (selon les conditions de polymérisation des produits utilisés) et de façon générale tout procédé de durcissement connu applicable à la matière liquide ou gélatineuse utilisée. Le durcissement peut également n'être que partiel. Dans ce cas, il subsiste dans le coeur de la lentille une partie encore liquide ou visqueuse.

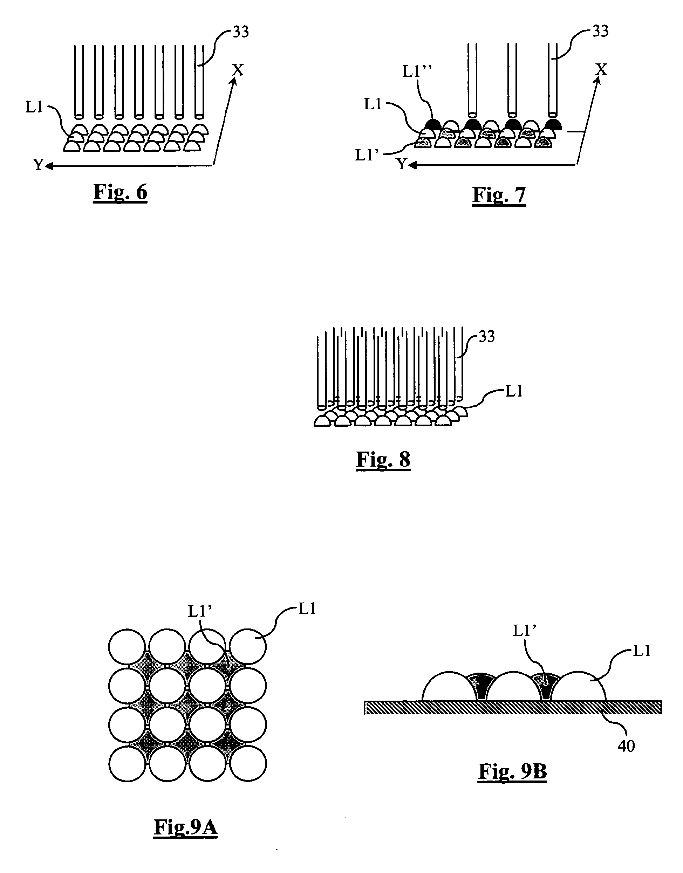

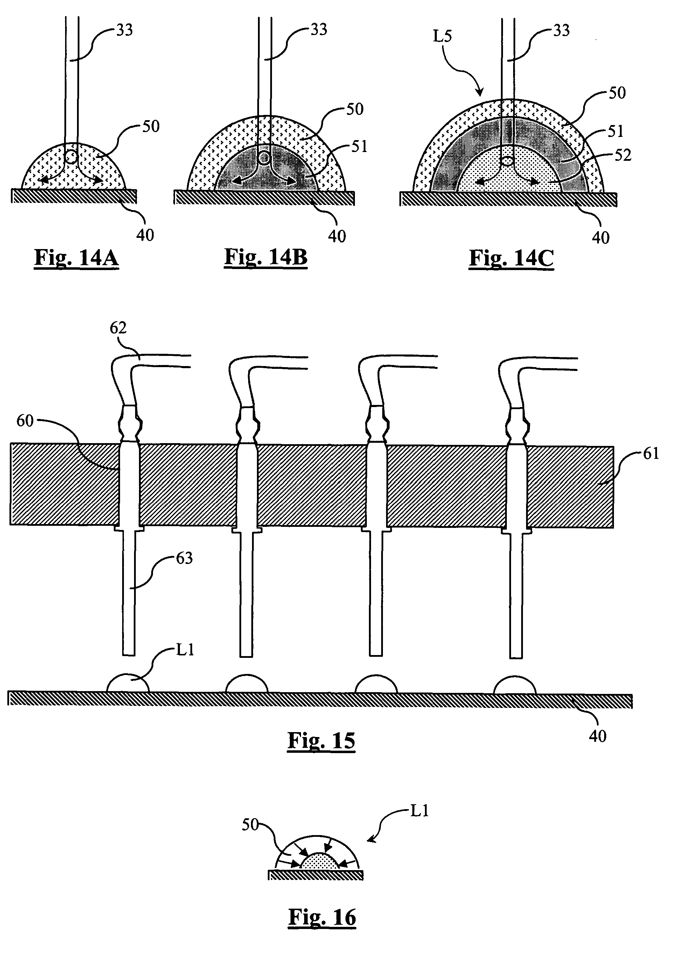

L'invention est de façon générale applicable à la réalisation de toute pièce ayant une fonction optique. Pour l'obtention de cadences de fabrication satisfaisantes, plusieurs lentilles L1i sont de préférence réalisées simultanément en utilisant une pluralité de seringues 30i, comme illustré en figure 5. La quantité de matière 50 dispensée par chaque seringue est contrôlée ici en disposant entre le pousse-seringue 20 et les seringues une plaque 21 qui pousse simultanément les pistons de toutes les seringues. D'autres exemples de dispositifs permettant de réaliser collectivement des lentilles selon l'invention seront décrits plus loin en relation avec les figures 16 et 17.

Divers modes de réalisation de matrices de lentilles selon l'invention sont représentés sur les figures 6 à 9B.

Sur la figure 6, une seule rangée d'aiguilles de dispensation 33 est utilisée pour réaliser une première rangée de lentilles L1, puis la surface support est déplacée en X et/ou en Y et l'opération est répétée plusieurs fois pour obtenir la matrice de lentilles.

Sur la figure 7, une seule rangée d'aiguilles de dispensation 33 est également utilisée, pour réaliser ici des premières rangées de lentilles L1 avec une première matière durcissable, puis la surface support est déplacée en X et/ou en Y et l'opération est répétée plusieurs fois en utilisant une seconde matière durcissable puis une troisième matière durcissable, pour obtenir une matrice composite de lentilles de type L1, L1', L1", chaque type de lentille étant constitué d'une matière différente et ayant des propriétés optiques différentes. Comme représenté, les rangées de lentilles L1, L1' et L" peuvent être entrelacées en utilisant des aiguilles 33 dont l'espacement est supérieur à l'espacement entre deux lentilles de la matrice.

Sur la figure 8, une matrice d'aiguilles de dispensation 33 est utilisée pour réaliser en une seule étape une matrice de lentilles L1.

Le matriçage des lentilles peut être réalisé de manière que des lentilles se chevauchent. Comme représenté par une vue de dessus en figure 9A et en coupe en figure 9B, on réalise par exemple une matrice composite comprenant des lentilles de type L1 et des lentilles de type L1' et dans laquelle les lentilles de type L1' chevauchent les lentilles de type L1. A cet effet, la matrice comprenant des lentilles de type L1 est tout d'abord formée et polymérisée avant de réaliser la matrice comprenant des lentilles de type L1', qui est ensuite elle-même polymérisée. Les conditions de polymérisation de chaque matrice de lentilles ne sont pas nécessairement identiques et dépendent du matériau utilisé pour réaliser chaque matrice.

Un grand nombre de variantes de réalisation peuvent bien entendu être conçus par l'homme de l'art à partir des exemples décrits. De plus, la matrice de lentilles ne présente pas nécessairement un pas régulier.

La réalisation d'une matrice de lentilles sur un support de formation commun implique que les lentilles soient ensuite détachées du support ou que le support, en verre ou en résine, soit découpée en microplaquettes comprenant chacune une lentille. Ce dernier mode de réalisation est particulièrement adapté à la réalisation d'une matrice de lentilles sur wafer de semi-conducteur, après dépôt d'une couche support de lentilles sur une matrice d'imageur intégrée sur le wafer. Dans ce cas c'est un capteur d'image "complet" (imageur intégré sur semi-conducteur et son bloc optique associé) qui est avantageusement réalisé collectivement.

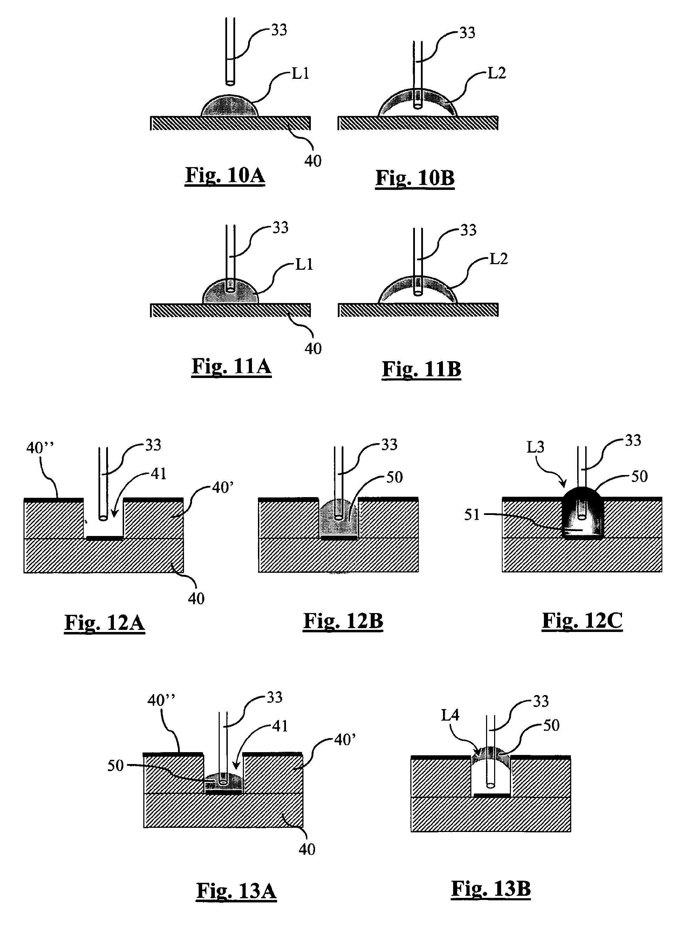

Les figures 10A, 10B illustrent un mode de réalisation du procédé de l'invention permettant de réaliser une lentille L2 comprenant une poche de gaz qui modifie ses propriétés optiques. En figure 10A, une lentille L1 (non durcie) est formée de la manière précédemment décrite. A l'étape illustrée par la figure 10B, l'extrémité de l'aiguille est enfoncée dans la lentille L1 et une quantité de gaz est injectée dans la lentille, pour obtenir la lentille L2 avant l'étape de durcissement.

Dans une variante illustrée en figure 11A, 11B, l'aiguille 33 est rapprochée suffisamment du support 40 de manière que son extrémité distale se trouve à l'intérieur de la lentille L1 après que cette dernière est formée. L'étape suivante, illustrée en figure 11B, est identique à celle illustrée en figure 10B mais ne nécessite pas que l'aiguille soit introduite a posteriori dans la lentille L1 pour injecter le gaz.

Les figures 12A à 12C, 13A, 13B illustrent un mode de réalisation du procédé selon l'invention dans lequel la surface support 40 comporte une cavité 41 (ou plusieurs cavités) pour recevoir la lentille à réaliser (ou les lentilles à réaliser collectivement). Une telle cavité est aisée à réaliser sur un support 40 en semi-conducteur. Une couche intermédiaire, par exemple une couche d'oxyde 40', est réalisée sur le semi-conducteur 40. La couche d'oxyde 40' est ensuite gravée pour former la cavité 40' puis est recouverte par une résine 40".

Ce mode de réalisation permet par exemple de fabriquer une lentille ayant une base de forme différente de la forme habituellement ronde d'une lentille, par exemple une lentille à base carrée. Une telle forme est avantageusement plus adaptée à la forme carrée de la matrice de pixels d'un imageur. De plus, des lentilles incluant un gaz ou des matières d'indices optiques différents peuvent être réalisés. Ainsi, les figures 12A à 12C illustrent la fabrication d'une lentille composite L3. A l'étape de la figure 12A, l'aiguille 33 est amenée en regard de la cavité 41 de manière que son extrémité distale pénètre sensiblement dans la cavité. A l'étape illustrée en figure 12B, la matière 50 est déposée dans la cavité. L'extrémité distale de l'aiguille 33 se trouve alors à l'intérieur du volume de matière 50. A l'étape illustrée en figure 12C, une seconde matière 51, liquide ou gélatineuse, est injectée au sein de la matière 50, créant ainsi un coeur de lentille d'indice optique différent du reste de la lentille L3. D'autres matières peuvent être injectées dans la lentille, par exemple pour obtenir un gradient d'indice optique. Les matières les plus proches du coeur de la lentille ne sont pas nécessairement durcies. Elles peuvent même être d'un type non durcissable.

Sur les figures 13A et 13B, des étapes similaires sont mises en oeuvre pour injecter une poche de gaz dans la lentille au lieu d'injecter la seconde matière 51. On obtient une lentille L4 qui contient une poche de gaz, comme la lentille L2 en figure 10B ou 11B.

L'homme de l'art notera que dans les divers modes de réalisation utilisant une cavité, la forme de tout ou partie des bords latéraux de la lentille est imposée par les parois de la cavité. Seule la face supérieure de la lentille soumise aux forces interfaciales sans compensation mécanique présente une forme bombée.

Une lentille composite L5 à plusieurs indices optiques est également réalisable de la manière représentée sur les figures 14A à 14C. En figure 14A une première quantité de matière 50 est déposée au moyen de l'aiguille 33 sur une surface support 40 parfaitement plate. Comme précédemment décrit, l'extrémité distale de l'aiguille est agencée ici de manière à se trouver au coeur de la quantité de matière 50 lorsque celle-ci est déposée sur le support 40. En figure 14B, une quantité de matière 51 est injectée au coeur de la matière 50 et en figure 14C une autre quantité de matière 52 est injectée au coeur de la matière 51. En allant de l'extérieur vers le coeur de la lentille L5, on trouve ainsi des couches concentriques de matière 50, puis de matière 51, et enfin de matière 52.

La figure 15 représente un dispositif de dispensation comprenant une pluralité de buses de dispensation 60 maintenues par une plaque 61 et reliées chacune à une canalisation 62 qui est alimentée en matière liquide ou gélatineuse 50 par une micro-pompe fluidique (non représentée). Chaque buse 60 comporte une extrémité 63 de faible diamètre ayant la même fonction qu'une aiguille de dispensation et s'étendant vers le bas en direction du support 40. Dans la présente demande et les revendications, on entend ainsi par "aiguille" tout moyen de dispensation de la matière liquide ou gélatineuse, notamment les buses 63 qui viennent d'être décrites.

Il apparaîtra clairement à l'homme de l'art que le procédé selon l'invention est susceptible de diverses applications et autres variantes de réalisation, notamment en combinant les exemples de réalisation qui viennent d'être décrits.

L'invention est applicable notamment à la réalisation de capteurs d'image numériques ou à la réalisation de blocs optiques pour capteurs d'image, par exemple des capteurs CMOS, notamment dans le cadre de la fabrication d'appareil photographiques ou de modules photographiques intégrés dans des téléphones portables.

En ce qui concerne le choix de matériaux, l'homme de l'art notera que l'utilisation de matériaux non miscibles permet d'obtenir des lentilles d'indice variables tandis que l'utilisation de matériaux miscibles permet d'obtenir des lentilles présentant un gradient d'indice, une étape de polymérisation adéquate étant conduite après réalisation des lentilles.

Peuvent également être utilisés des matériaux en soi connus présentant la propriété de se contracter ("shrinkage") pendant leur polymérisation, par exemple des colles. De tels matériaux permettent de diminuer la taille de la lentille déposée, sans destruction de la forme initiale de la lentille, dictée par les énergies d'interface. Pour fixer les idées, la figure 16 représente une variante de l'étape de durcissement de la lentille L1 représentée en figure 3C. Cette figure illustre la diminution de la taille de lentille pendant une étape de polymérisation thermique lorsqu'une matière à fort taux de contraction est utilisée pour réaliser la lentille.

## Revendications

1. Procédé de fabrication d'au moins une lentille optique à partir d'une matière (50) liquide ou gélatineuse durcissable, **caractérisé en ce qu'**il comprend:
- une étape de dépôt d'un volume calibré de la matière (50) sur un support (40) de formation de lentille, au moyen d'une aiguille creuse (33, 63) de faible diamètre, de manière que le volume de matière déposée présente au moins une partie convexe sous l'effet d'énergies d'interface, et
- une étape de durcissement de tout ou partie du volume de matière déposé.

2. Procédé selon la revendication 1, dans lequel le volume de matière durci est utilisé comme lentille en le laissant sur son support de formation initial, prévu à cet effet transparent et utilisé comme support de lentille.

3. Procédé selon l'une des revendications 1 à 2, dans lequel le durcissement du volume de matière est partiel et la lentille contient, après durcissement, au moins une partie encore liquide ou gélatineuse.

4. Procédé selon l'une des revendications 1 à 3, dans lequel le volume de matière est déposé sur une partie plate du support de formation (40) et la lentille (L1, L2, L5) présente avant durcissement une forme générale convexe sous l'effet des énergies d'interface.

5. Procédé selon l'une des revendications 1 à 3, dans lequel le volume de matière est déposée dans une cavité (41) prévue dans le support de formation (40), et la lentille (L3, L4) présente avant durcissement une face supérieure de forme convexe sous l'effet des énergies d'interface.

6. Procédé selon l'une des revendications 1 à 5, dans lequel le volume de matière est déposé sur le support de formation (40) sans que l'extrémité de l'aiguille (33) pénètre dans le volume de matière déposé (fig. 10A).

7. Procédé selon l'une des revendications 1 à 5, dans lequel le volume de matière est déposé sur le support de formation avec une distance entre le support de formation (40) et l'extrémité de l'aiguille (33) qui est telle que l'extrémité de l'aiguille se trouve à l'intérieur du volume de matière après que celui-ci est déposé.

8. Procédé selon l'une des revendications 1 à 7, comprenant une étape consistant à injecter au moins un gaz à l'intérieur du volume de matière, pour obtenir une lentille (L2, L4) renfermant une poche de gaz.

9. Procédé selon l'une des revendications 1 à 8, comprenant au moins une étape consistant à injecter une autre matière liquide ou gélatineuse (51, 52) à l'intérieur du volume de matière déposé, pour obtenir une lentille composite (L3, L5) comprenant au moins deux couches sensiblement concentriques ayant des indices optiques différents.

10. Procédé selon l'une des revendications 1 à 9, comprenant le dépôt simultané d'une pluralité de volumes de matière sur le support de formation (40,), au moyen d'une pluralité d'aiguilles (33, 63) de faible diamètre, pour obtenir une matrice de lentilles.

11. Procédé selon l'une des revendications 1 à 10, comprenant plusieurs étapes simultanées ou successives de dépôt simultané d'une pluralité de volume de matière sur le support de formation (40), au moyen d'une pluralité d'aiguilles de faible diamètre, en utilisant des matières différentes, pour obtenir une matrice composite de lentilles (L1, L1', L1") comprenant des groupes de lentilles ayant des propriétés optiques différentes.

12. Procédé de fabrication d'un capteur d'image numérique, notamment un capteur CMOS, comprenant une étape de fabrication d'une lentille conduite conformément au procédé selon l'une des revendications 1 à 11.

13. Procédé de fabrication d'un appareil photographique, comprenant une étape de fabrication d'un capteur d'image selon la revendication 12.

14. Procédé de fabrication d'un bloc optique pour capteur d'image numérique, notamment un capteur CMOS, comprenant une étape de fabrication d'une lentille conduite conformément au procédé selon l'une des revendications 1 à 11.
